Europäisches Patentamt

European Patent Office

Office européen des brevets

(19)

(11) EP 0 671 013 B1

(12) FASCICULE DE BREVET EUROPEEN

(45) Date de publication et mention
de la délivrance du brevet:
**08.01.1997 Bulletin 1997/02**

(21) Numéro de dépôt: **94900855.1**

(22) Date de dépôt: **16.11.1993**

(51) Int Cl.6: **G01R 33/00**

(86) Numéro de dépôt international:
**PCT/FR93/01121**

(87) Numéro de publication internationale:
**WO 94/12890 (09.06.1994 Gazette 1994/13)**

(54) **STATION DE MESURE MAGNETIQUE POUR BATIMENTS NAVALS**

ANORDNUNG ZUR MAGNETISCHER MESSUNG FÜR SCHIFFE

MAGNETIC MEASUREMENT STATION FOR NAVAL VESSELS

(84) Etats contractants désignés:
**DE GB**

(30) Priorité: **27.11.1992 FR 9214306**

(43) Date de publication de la demande:
**13.09.1995 Bulletin 1995/37**

(73) Titulaire: **THOMSON-CSF**
**75008 Paris (FR)**

(72) Inventeurs:
- **DUTHOIT, François-Marie Thomson-CSF SCPI**
**F-92402 Courbevoie Cédex (FR)**
- **PERIOU, Jean-Jacques Thomson-CSF SCPI**
**F-92402 Courbevoie Cédex (FR)**

(74) Mandataire: **Simonnet, Christine et al**
**THOMSON-CSF-S.C.P.I.,**
**13, Avenue du Président**
**Salvador Allende**
**94117 Arcueil Cédex (FR)**

(56) Documents cités:
**WO-A-87/02324**      **FR-A- 2 620 419**
**GB-A- 2 221 037**      **US-A- 2 393 466**

- **Conference on Precision Electromagnetic
Measurements; IEEE New York US 1976 page
194-196; M.H.Lackey: "Special coil facilities for
magnetic ...**

## Description

La présente invention se rapporte aux stations de mesures magnétiques pour bâtiments navals. Elle concerne plus particulièrement une station apte à mesurer la signature magnétique due aux courants de Foucault engendrés dans un bâtiment naval en matériau amagnétique conducteur de l'électricité. La signature magnétique d'un bâtiment correspond à la perturbation du champ magnétique terrestre qu'il engendre.

La signature magnétique d'un bâtiment naval permet de le repérer, de le suivre et éventuellement de guider ou de mettre à feu des engins destinés à le détruire. Il est important pour préserver le bâtiment naval, de minimiser voire d'annuler cette signature magnétique, de manière à empêcher sa détection par une méthode magnétique.

Les bâtiments navals en matériaux ferromagnétiques tel que le fer s'aimantent. Cette aimantation comprend principalement : une partie permanente sensiblement constante et une partie induite variable. La signature magnétique du bâtiment est constituée principalement par son aimantation permanente et par son aimantation induite.

L'aimantation permanente est due à la nature des matériaux utilisés dans le bâtiment naval. Elle est sensiblement constante et ne fluctue qu'avec le temps. L'aimantation induite variable dépend de l'orientation du bâtiment dans le champ magnétique, de son cap et de son inclinaison due au roulis et au tangage.

D'autres bâtiments navals sont construits en matériau conducteur de l'électricité mais non ferromagnétique : c'est le cas de l'aluminium ou de certains aciers inoxydables par exemple. Pour ces matériaux l'aimantation permanente et l'aimantation induite sont négligeables. En revanche, les mouvements du bâtiment entraînent l'apparition de courants de Foucault dans sa structure. Ces courants sont d'autant plus importants que le matériau est bon conducteur de l'électricité. Les courants de Foucault induisent un champ magnétique qui perturbe le champ magnétique terrestre. La signature magnétique du bâtiment est due à ces courants de Foucault.

On notera que dans les bâtiments ferromagnétiques, la contribution des courants de Foucault à la signature magnétique est considérée comme négligeable.

Les courants de Foucault prennent naissance dès qu'il y a une variation du flux magnétique terrestre dans le temps, cette variation étant liée à un mouvement du bâtiment. Les courants de Foucault sont proportionnels à la fréquence et à l'amplitude du mouvement du bâtiment. Le mouvement de roulis a une amplitude et une fréquence beaucoup plus grandes que celles des mouvements de tangage et de lacet et donc les courants de Foucault sont dus principalement au mouvement de roulis. Des stations de mesure de la signature magnétique due aux courants de Foucault engendrés dans un bâtiment naval sont connues. On fait osciller un bâtiment naval autour de son axe longitudinal au dessus de capteurs magnétiques disposés au fond de la mer. Chaque capteur mesure le champ magnétique à différents instants. Pour faire osciller le bâtiment et lui donner un mouvement de roulis, la méthode la plus utilisée consiste à commander le passage babord-tribord d'hommes d'équipage. On peut aussi utiliser des câbles et une grue ou bien s'ils existent les ballasts servant à stabiliser le bâtiment. Dans tous les cas la mise en oeuvre est lourde et peu reproductible.

Une autre méthode consiste à simuler le mouvement de roulis en gardant le bâtiment immobile au dessus d'un réseau de capteurs magnétiques. On produit autour du bâtiment un champ magnétique tournant. Pour cela, on dispose d'au moins un ensemble de trois boucles conductrices parcourues par du courant alternatif, l'une est placée à plat horizontalement sous le bâtiment et les autres verticalement de part et d'autre du bâtiment. La boucle horizontale produit un champ magnétique vertical et les deux boucles verticales un champ magnétique horizontal, transversal au bâtiment. Les intensités et les pulsations des courants qui circulent dans les boucles sont calculées pour obtenir une bonne simulation du roulis. L'inconvénient majeur de cette méthode réside dans la mise en place des boucles verticales. Leur présence rend difficile la manoeuvre du bâtiment. De plus, cette station n'est pas compatible avec les stations dites "de passage", dans lesquelles le bâtiment fait au moins un passage au dessus d'au moins un réseau linéaire de capteurs magnétiques. Il est toujours plus difficile de maintenir le bâtiment immobile que de le faire se déplacer.

Le brevet FR-A-2 620 419 montre un exemple de station de mesure comportant une bobine générant un champ magnétique vertical et à la verticale de cette bobine, une installation verticale générant un champ magnétique horizontal.

L'article "Conference on Precision Electromagnetic Measurements " IEEE New York US 1976 pages 194-196 montre une station de mesure avec trois jeux de bobines perpendiculaires capables de générer des champs magnétiques simulant les conditions géomagnétiques de tous lieux de croisière.

La présente invention propose une station de mesures de la signature magnétique d'un bâtiment naval compatible avec les stations dites "de passage".

Elle est apte à mesurer la signature magnétique due à des courants de Foucault engendrés dans la structure du bâtiment lors d'un roulis.

Elle comporte comme les stations dites "de passage", au moins une ligne de capteurs magnétiques et cette ligne coopère avec des moyens pour générer, autour du bâtiment, un champ magnétique tournant simulant un roulis. Selon l'invention, le champ magnétique tournant est généré par des conducteurs longitudinaux alimentés en courant, installés à plat sensiblement parallèlement à un axe, le bâtiment naval effectuant au moins un passage sensiblement le long de cet axe.

Les conducteurs sont de préférence disposés au fond de la mer. Ils sont alimentés avantageusement par un courant dont la fréquence est grande devant celle d'un roulis réel.

Préférentiellement les conducteurs ont une longueur au moins égale à celle du bâtiment et l'espace entre deux conducteurs successifs est petit par rapport à leur longueur.

La ligne de capteurs est disposée transversalement à l'axe de passage du bâtiment, sensiblement au milieu des conducteurs.

Le bâtiment est réalisé dans un matériau amagnétique conducteur de l'électricité.

Les conducteurs peuvent coopérer de manière à former au moins un ensemble de trois boucles avec une boucle centrale et deux boucles latérales.

Selon une variante les conducteurs peuvent être reliés d'un côté à un point commun et de l'autre à une alimentation.

L'invention concerne aussi un procédé de mesure pour la mise en oeuvre de la station.

D'autres particularités et avantages de l'invention apparaîtront dans la description suivante présentée à titre d'exemple non limitatif en regard des figures annexées qui représentent :

- la figure 1 : une station de type connu pour mesurer la signature magnétique due aux courants de Foucault d'un bâtiment naval;
- la figure 2 : une station, selon l'invention, apte à mesurer la signature magnétique due aux courants de Foucault d'un bâtiment naval;
- la figure 3 : un montage des conducteurs et de leur alimentation;
- les figures 4A et 4B: la répartition du champ magnétique vertical et horizontal transversalement à l'axe de passage du bâtiment, lorsque les conducteurs sont alimentés soit par des courants engendrant un champ magnétique vertical soit par des courants engendrant un champ magnétique horizontal ;
- la figure 5 : un autre montage des conducteurs et de leur alimentation;
- la figure 6 : encore un autre montage des conducteurs et de leur alimentation.

Sur ces figures les mêmes éléments portent les mêmes références et les échelles ne sont pas respectées dans un souci de clarté.

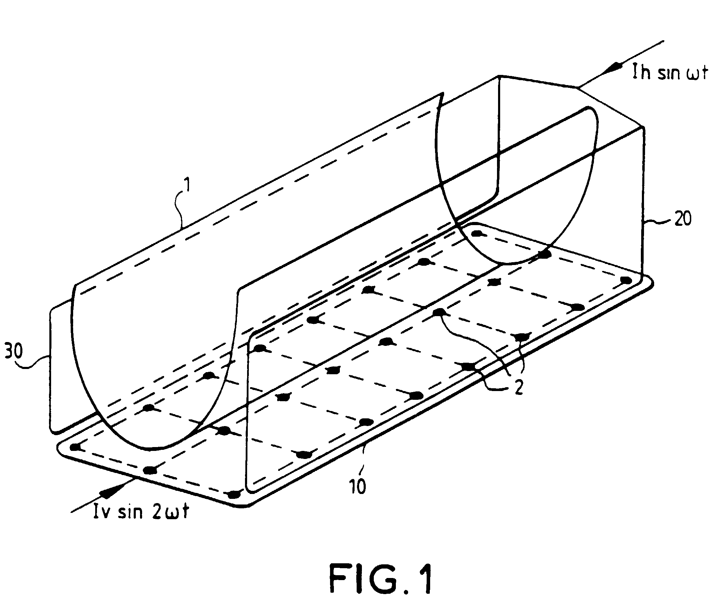

La figure 1 représente une station de mesure de la signature magnétique due aux courants de Foucault d'un bâtiment naval 1 selon l'art connu. Le bâtiment 1 est réalisé dans un matériau conducteur de l'électricité amagnétique. Il est immobile au dessus d'un réseau de capteurs magnétiques 2. Ces capteurs magnétiques 2 sont installés à plat au fond de la mer et sont disposés selon deux directions orthogonales, par exemple l'une dans la direction de l'axe principal du bâtiment et l'autre transversalement.

Ces capteurs magnétiques 2 mesurent le champ magnétique sous le bâtiment. Pour mesurer la signature magnétique due aux courants de Foucault engendrés par un roulis réel, on produit un champ magnétique tournant autour de la coque du bâtiment. Ce champ magnétique doit correspondre à celui qui serait induit par les courants de Foucault prenant naissance dans la structure du bâtiment lors du roulis réel.

Le champ magnétique tournant aura une composante verticale Bv et une composante horizontale Bh transversale à l'axe du bâtiment. La composante horizontale parallèle à l'axe du bâtiment 1 est négligeable dans un roulis.

Pour produire le champ magnétique tournant on utilise trois ensembles conducteurs 10,20,30 parcourus par des courants électriques alternatifs. Chaque ensemble conducteur 10,20,30 est en forme de boucle. La première boucle 10 est installée horizontalement au fond de la mer à plat sous le bâtiment. Elle produit la composante verticale Bv du champ magnétique tournant. La deuxième 20 et la troisième 30 boucles sont installées verticalement, de part et d'autre du bâtiment 1, à proximité des flancs de celui-ci. Elles sont dans un plan parallèle au plan de symétrie du bâtiment 1. Elles produisent la composante Bh horizontale du champ magnétique tournant. Cette composante est transversale à l'axe principal du bâtiment 1.

La boucle 10 est parcourue par un courant électrique de forme : Iv sin2ωt et les boucles 20 et 30 par un courant de forme : Ih sinωt. Iv et Ih sont les amplitudes des courants dans les boucles. La pulsation dans la boucle 10 est double de celle dans les boucles 20 et 30 car, dans un mouvement de roulis, la fréquence de la composante verticale Bv du champ magnétique crée est double de celle de la composante horizontale Bh. Les mesures des capteurs magnétiques sont ensuite traitées et analysées pour obtenir seulement la signature magnétique due aux courants de Foucault du bâtiment. En effet les mesures faites par les capteurs magnétiques 2 tiennent compte de la signature magnétique du bâtiment, du champ magnétique généré par les boucles et du champ magnétique terrestre. Il faut éliminer le champ magnétique généré par les boucles et le champ magnétique terrestre.

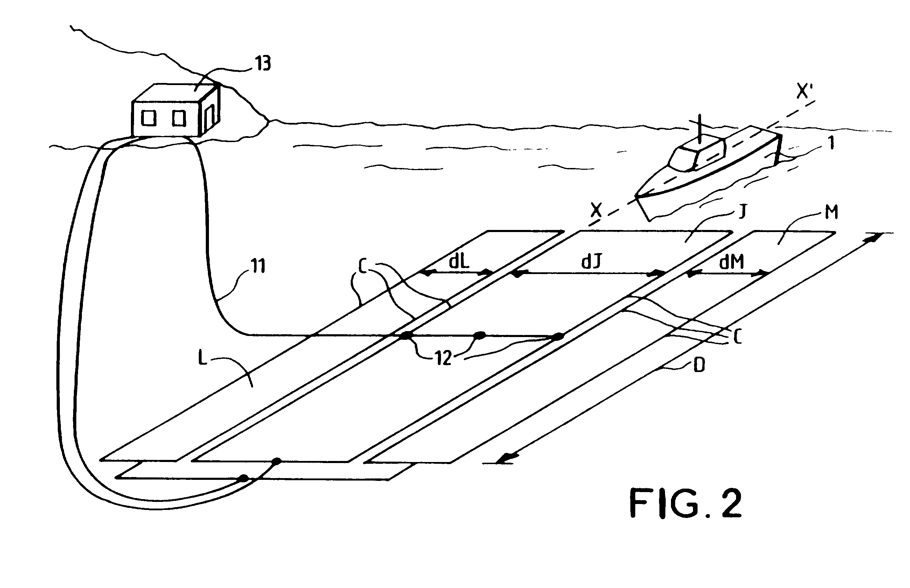

La figure 2 représente une station de mesure de la signature magnétique d'un bâtiment naval, conforme à l'invention. Elle est apte à mesurer la signature magnétique due aux courants de Foucault d'un bâtiment 1, s'il est en matériau conducteur amagnétique. Elle est aussi apte à mesurer la signature magnétique due à son aimantation s'il est en matériau ferromagnétique. Elle comporte au moins une ligne 11 de capteurs magnétiques 12 disposée à plat au fond de la mer par exemple. Ces capteurs 12 sont reliés à un centre de réception 13 des données mesurées et de traitement qui peut être à terre. Le bâtiment 1 dont on veut mesurer la signature magnétique se déplace selon un axe XX' au dessus de la ligne 11 de capteurs magnétiques 12, On crée un champ magnétique tournant autour de la coque du bâtiment 1. Ce champ magnétique tournant est créé par un ensemble de conducteurs C longitudinaux alimentés électriquement et disposés à plat sensiblement parallèlement à l'axe XX' de passage du bâtiment 1. Ces conducteurs C sont avantageusement déposés sur le fond de la mer.

Sur la figure 2, les conducteurs C longitudinaux coopèrent de manière à former au moins un ensemble de trois boucles L, J, M. La longueur D des conducteurs est au moins égale à celle du bâtiment et l'intervalle dL, dJ, dM entre deux conducteurs C successifs est petit devant cette longueur D. L'intervalle entre deux conducteurs est choisi en fonction de la hauteur d'eau, pour homogénéiser le champ magnétique dans le volume d'eau concerné par la mesure. La boucle centrale J produit la composante verticale Bv du champ magnétique tournant tandis que les deux boucles latérales L, M coopèrent pour produire la composante horizontale Bh du champ magnétique tournant. Cette composante est transversale à l'axe XX' de passage du bâtiment 1. La boucle J est reliée à une alimentation fournissant un courant d'amplitude Iv tandis que les boucles L et M sont reliées à une alimentation fournissant un courant d'amplitude Ih. Les deux alimentations ne sont pas représentées. En ajustant les courants, intensité et sens dans les conducteurs C on peut créer soit un champ magnétique vertical sans champ magnétique horizontal, soit un champ magnétique horizontal transversal à l'axe XX' de passage du bâtiment 1 sans champ vertical, soit la somme des deux. La ligne 11 de capteurs magnétiques 12 est disposée transversalement à l'axe XX' de passage du bâtiment 1. Cette disposition est classique dans les stations de mesure de la signature magnétique des bâtiments ferromagnétiques. Chaque capteur 12 est de préférence disposé entre deux conducteurs C longitudinaux. La ligne 11 des capteurs magnétique 12 est avantageusement à égale distance des extrémités des conducteurs C.

Lorsque les boucles ne sont pas alimentées et que le bâtiment naval fait un passage au dessus des capteurs magnétiques, on observe que la fréquence du champ magnétique mesuré est proche de la fréquence du roulis réel du bâtiment naval.

Lorsque les boucles sont alimentées, les capteurs reçoivent à la fois le champ magnétique généré par le roulis simulé et celui généré par le déplacement du bâtiment.

Si la fréquence du courant dans les boucles est égale à celle du roulis réel, on ne sait pas séparer les deux champs magnétiques mesurés.

On propose d'alimenter les boucles avec un courant dont la fréquence est plus grande que celle du roulis réel.

Si k (k est supérieur à 1) est le rapport entre la fréquence du roulis simulé et la fréquence du roulis réel pour lequel on fait la mesure, il suffit, par un traitement approprié de diviser par k les mesures du champ magnétique pour obtenir un résultat correct.

Les mesures des capteurs magnétiques 12 correspondent au champ magnétique généré par les conducteurs longitudinaux C, au champ magnétique terrestre statique et au champ magnétique dû aux courants de Foucault. C'est seulement ce dernier champ magnétique que l'on désire obtenir. Pour éliminer le champ magnétique généré par les conducteurs longitudinaux C on procède par soustraction : on mesure d'une part le champ magnétique en alimentant les conducteurs longitudinaux sans le bâtiment et d'autre part le champ magnétique lors du passage du bâtiment, les conducteurs étant alimentés. Puis on soustrait les données obtenues lors des deux mesures.

Le champ magnétique terrestre statique est sensiblement constant sur une courte durée. Ce champ magnétique peut être éliminé par un filtrage passe-haut des données mesurées. La fréquence de coupure du filtre est inférieure à la fréquence du champ magnétique dû aux courants de Foucault.

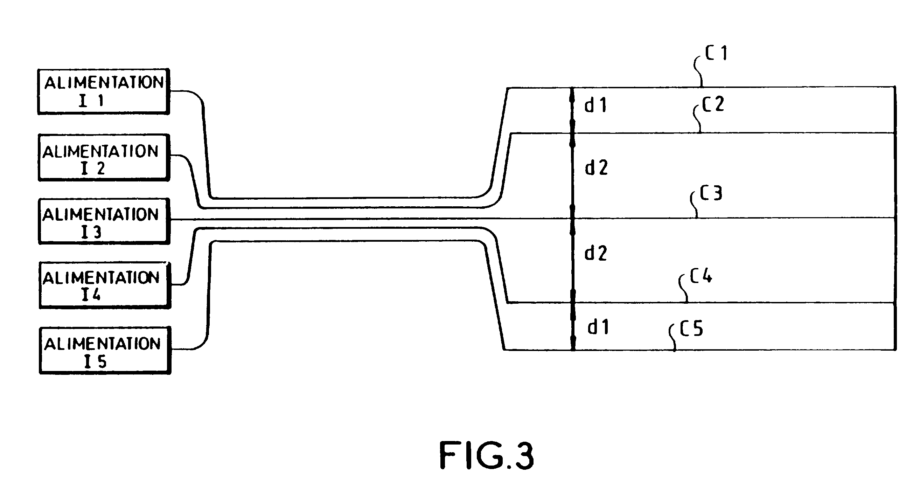

La figure 3 représente un montage préféré des conducteurs et de leur alimentation électrique. Au lieu d'utiliser deux alimentations et des boucles distinctes, on peut utiliser plusieurs conducteurs longitudinaux (C1,C2,C3,C4,C5) reliés chacun d'un côté à une alimentation fournissant respectivement des courants I1,I2,I3,I4,I5 et de l'autre à un point commun. Les courants I1,I2,I3,I4,I5 sont ajustés pour induire le champ magnétique tournant souhaité. De préférence, la somme de ces courants est nulle pour s'affranchir d'un fil de retour. On appelle d1 la distance entre les conducteurs C1 et C2 et entre les conducteurs C4 et C5. On appelle d2 la distance entre les conducteurs C2 et C3 et entre les conducteurs C3 et C4.

Dans chaque conducteur, le courant est de la forme :

$$Ii = IVi + IHi$$

avec $IVi = Iv^i \sin 2\omega t$ et $IHi = Ih^i \sin \omega t$
IVi contribue à induire la composante verticale du champ magnétique et IHi la composante horizontale.

Exemple numérique :

On considère que :

- le bâtiment, en matériau conducteur amagnétique, se déplace selon un axe Nord-Sud
- les conducteurs sont installés à une profondeur de 10 mètres.
- la géométrie des conducteurs est telle que d1 = 12 mètres et d2 = 24 mètres.
- la fréquence, du courant IHi est égale à 2Hz, celle du courant IVi est égale à 4Hz. La fréquence propre du mouvement de roulis est de l'ordre de 0,25 Hz.

Les valeurs des intensités $Iv^i$ et $Ih^i$ des courants IVi et et IHi sont consignées dans le tableau suivant :

| i | 1 | 2 | 3 | 4 | 5 |
|---|---|---|---|---|---|
| Iv en Ampère | +20 | -6 | 0 | +6 | -20 |
| Ih en Ampère | -18 | +17 | +2 | +17 | -18 |

Les valeurs réelles des composantes du champ magnétique du au mouvement de roulis, sont calculées en tenant compte de l'angle maximum du mouvement de roulis et du champ magnétique terrestre statique.

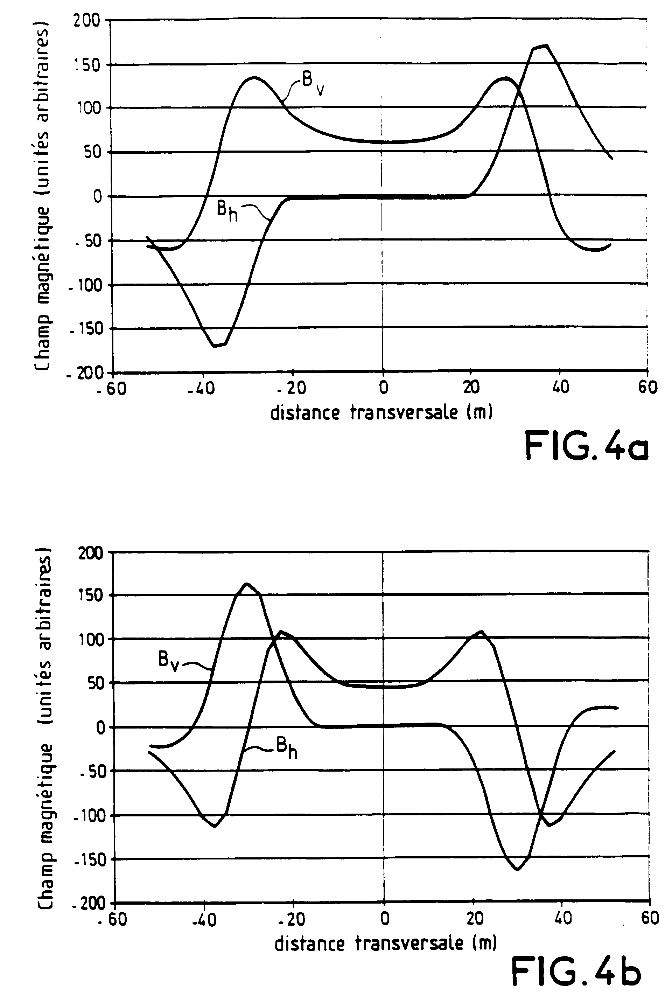

Les figures 4a et 4b représentent respectivement la répartition du champ magnétique vertical Bv et du champ magnétique horizontal Bh, transversalement à l'axe de passage du bâtiment lorsque l'on alimente les conducteurs Ci avec les courants IVi et IHi séparement.

Il ressort de ces graphiques que l'on peut produire, sur une distance de 30 mètres environ, un champ magnétique horizontal Bh, ou vertical Bv presque nul pendant que respectivement le champ magnétique vertical Bv ou horizontal Bh garde une valeur sensiblement constante.

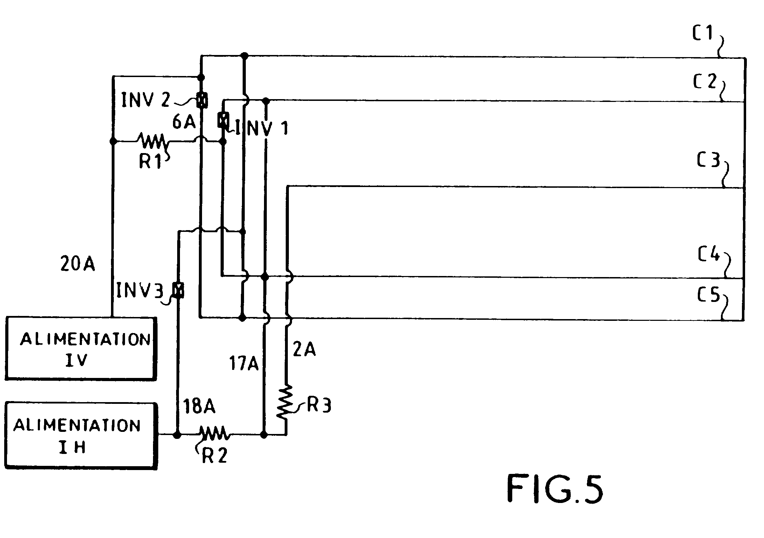

La figure 5 représente un troisième montage des conducteurs et de leur alimentation électrique. On utilise deux alimentations : l'une IV fournissant les courants IVi à la fréquence 2f pour produire la composante Bv du champ magnétique et l'autre IH fournissant les courants IHi à la fréquence f pour produire la composante Bh du champ magnétique. Les valeurs numériques indiquées sur la figure 5 correspondent à l'exemple numérique décrit précédemment. L'alimentation IV fournit un courant de 20 ampères dans les conducteurs C1 et C5. La résistance R1 connectée entre l'alimentation IV et les conducteurs C2 et C4 permet d'obtenir un courant de 6 ampères dans ces conducteurs.

L'alimentation IH fournit un courant de 18 ampères dans les conducteurs C1 et C5. La résistance R2 connectée entre l'alimentation IH et les conducteurs C2 et C4 permet d'obtenir un courant de 17 ampères dans ces conducteurs. La résistance R3 connectée entre la résistance R2 et le conducteur C3 permet d'obtenir un courant de 2 ampères dans ce conducteur. Des inverseurs INV1, INV2, INV3 permettent d'obtenir les courants négatifs. Le premier INV1 est connecté entre la résistance R1 et le conducteur C2, le deuxième INV2 est connecté entre l'alimentation IV et le conducteur C5, le troisième INV3 est connecté entre l'alimentation, IH et les conducteurs C1 et C5, Le conducteur C3 ne sert qu'à générer un champ magnétique horizontal. Un courant de faible intensité y circule mais il permet d'obtenir une meilleure homogénéité du champ magnétique tournant.

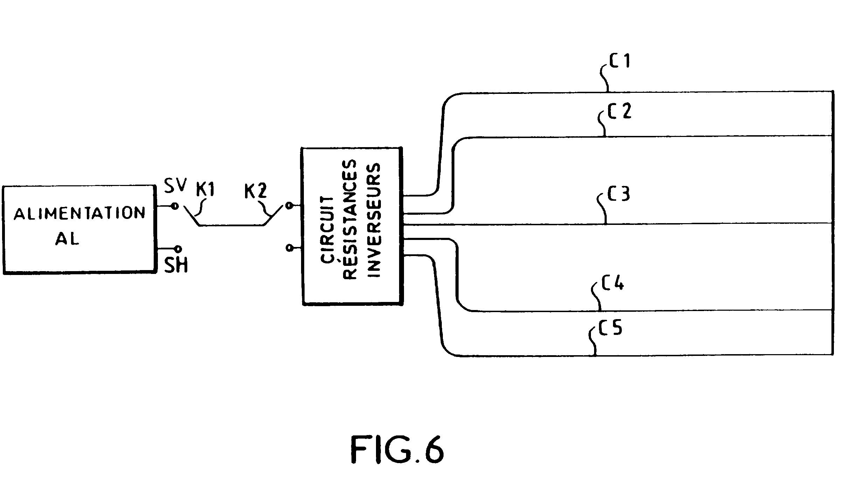

La figure 6 représente un quatrième montage des conducteurs et de leur alimentation.

Dans cette variante on n'utilise qu'une seule alimentation AL avec deux sorties SV et SH. La sortie SV fournit les courants IVi et la sortie SH les courants IHi. Un premier commutateur K1 avec deux entrées et une sortie permet de commuter sa sortie soit sur la sortie SV soit sur la sortie SH. La sortie du commutateur K1 est reliée à l'entrée d'un second commutateur K2 ayant une entrée et deux sorties. Les deux commutateurs K1 et K2 commutent ensemble. La sortie du commutateur K2 recevant les courants IVi est reliée aux conducteurs C1 à C5 par l'intermédiaire d'un circuit de résistance R1 et d'inverseurs (INV1,INV2) comparable à celui représenté à la figure 5. La sortie du commutateur K2 recevant les courant IHi est reliée aux conducteurs C1 à C5 par l'intermédiaire de résistances (R2,R3) et d'un inverseur INV3 comme sur la figure 5. Les circuits de résistances et d'inverseurs sont représentés sous forme de blocs. Lors d'un premier passage du bâtiment, le premier commutateur K1 étant positionné sur la sortie SV par exemple, on mesure le champ magnétique engendré par les courants IVi. Lors d'un second passage du bâtiment, après avoir commuté les commutateurs K1 et K2 on mesure le champ magnétique engendré par les courants IHi.

On reconstruit, à partir des deux mesures, la signature du bâtiment comme s'il n'avait effectué qu'un seul passage.

La station de mesure selon l'invention peut être utilisée avec des stations existantes permettant de faire des mesures sur des bâtiments ferromagnétiques. Il suffit seulement d'installer l'ensemble des conducteurs longitudinaux et leur alimentation électrique.

## Revendications

1. Station de mesure de la signature magnétique d'un bâtiment (1) naval, apte à mesurer la signature magnétique due aux courants de Foucault engendrés lors d'un roulis du bâtiment naval (1), comportant au moins une ligne (11) de capteurs magnétiques (12) coopérant avec des conducteurs (C) produisant lorsqu'ils sont alimentés en courant, autour du bâtiment (1), un champ magnétique tournant, possédant une composante horizontale et une composante verticale et simulant le roulis, caractérisé en ce que la fréquence du courant induisant la composante verticale est double de celle du courant induisant la composante horizontale, et en ce que les conducteurs (C) sont longitudinaux et sont installés à plat sensiblement parallèlement à un axe (XX'), le bâtiment naval (1) effectuant au moins un passage au dessus des conducteurs (C) sensiblement le long dudit axe (XX').

2. Station de mesure selon la revendication 1, caractérisée en ce que les conducteurs (C) sont disposés au fond de la mer.

3. Station de mesure selon l'une des revendications 1 ou 2, caractérisée en ce que la fréquence du courant alimentant les conducteurs (C) longitudinaux est grande devant celle d'un roulis réel du bâtiment naval.

4. Station de mesure selon l'une des revendications 1 à 3, caractérisée en ce que les conducteurs (C) ont une longueur (D) qui est au moins égale à celle du bâtiment naval (1).

5. Station de mesure selon l'une des revendications 1 à 4, caractérisée en ce que l'espacement (dL, dJ, dM) entre deux conducteurs (C) successifs est petit par rapport à leur longueur (D).

6. Station de mesure selon l'une des revendications 1 à 5, caractérisée en ce que la ligne (11) de capteurs magnétiques (12) est disposée transversalement à l'axe (XX') de passage du bâtiment (1), sensiblement au milieu des conducteurs (C).

7. Station de mesure selon l'une des revendications 1 à 6, caractérisée en ce que le bâtiment (1) est en matériau amagnétique, conducteur de l'électricité.

8. Station de mesure selon l'une des revendications 1 à 7, caractérisée en ce que les conducteurs (C) coopèrent de manière à former au moins un ensemble de trois boucles, avec une boucle centrale (J) alimentée par une première alimentation fournissant un courant destiné à produire la composante verticale (Bv) du champ magnétique et deux boucles latérales (L,M) alimentées par une seconde alimentation fournissant un courant destiné à produire la composante horizontale (Bh) du champ magnétique, cette composante étant transversale à l'axe (XX') de passage du bâtiment.

9. Station de mesure selon l'une des revendications 1 à 7, caractérisée en ce que les conducteurs (C1 à C5) sont reliés d'un côté tous à un point commun et de l'autre à une alimentation électrique.

10. Station de mesure selon la revendication 9, caractérisée en ce que les conducteurs sont au nombre de cinq.

11. Station de mesure selon l'une des revendications 9 ou 10, caractérisée en ce que la somme des courants circulant dans les conducteurs est nulle à chaque instant.

12. Station de mesure selon l'une des revendications 9 à 11, caractérisée en ce que dans chaque conducteur circule un courant qui est la somme d'un courant destiné à produire la composante horizontale du champ magnétique et d'un courant destiné à produire la composante verticale du champ magnétique.

13. Station de mesure selon l'une des revendications 9 à 12, caractérisée en ce que chaque conducteur (C1,C2,C3,C4,C5) est relié à une alimentation distincte (I1,I2,I3,I4,I5,).

14. Station de mesure selon la revendication 12, caractérisée en ce qu'une première alimentation (IH) fournit le courant destiné à produire la composante horizontale du champ magnétique et une deuxième alimentation (IV) fournit le courant destiné à produire la composante verticale du champ magnétique.

15. Station de mesure selon l'une des revendications 9 à 11 caractérisé en ce qu'une alimentation unique (AL) à deux sorties (SV, SH) fournit lors d'un passage du bâtiment (1) un courant destiné à produire une composante horizontale du champ magnétique et lors d'un autre passage du bâtiment courant destiné à produire la composante verticale du champ magnétique.

16. Procédé de mesure de la signature magnétique due aux courants de Foucault engendrés lors d'un roulis d'un bâtiment naval consistant

- à produire un champ magnétique tournant simulant le roulis et possédant une composante horizontale et une composante verticale à l'aide de conducteurs alimentés en courant, caractérisé en ce que la fréquence du courant induisant la composante verticale est double de celle du courant induisant la composante horizontale, et en ce que le procédé consiste à :
- recueillir un ensemble de données fourni par au moins une ligne de capteurs magnétiques coopérant avec les conducteurs électriques, ces conducteurs étant longitudinaux, disposés à plat sensiblement parallèlement à un axe, le bâtiment naval effectuant au moins un passage sensiblement le long de cet axe,
- recueillir un autre ensemble de données fourni par la ligne de capteurs magnétiques en l'absence du bâtiment naval,
- soustraire les deux ensembles de données pour obtenir un troisième ensemble de données.

17. Procédé de mesure selon la revendication 16, caractérisé en ce qu'il consiste à traiter au moins un des ensembles de données pour tenir compte du rapport entre la fréquence du roulis simulé et la fréquence du roulis réel.

18. Procédé de mesure selon l'une des revendications 16 ou 17, caractérisé en ce qu'il consiste à s'affranchir du champ magnétique terrestre statique par filtrage d'au moins un des ensembles de données.

**Patentansprüche**

1. Station zur Messung der magnetischen Kennung eines Schiffes (1), die die magnetische Kennung aufgrund der bei einer Rollbewegung des Schiffes (1) erzeugten Foucaultströme messen kann und mindestens eine Reihe (11) von magnetischen Meßsonden (12) besitzt, die mit Leitern (C) zusammenwirken, welche mit einem Strom gespeist werden und dann um das Schiff (1) ein drehendes Magnetfeld mit einer horizontalen und einer vertikalen Komponente erzeugen und so die Rollbewegung simulieren, dadurch gekennzeichnet, daß die Frequenz des die vertikale Komponente induzierenden Stroms doppelt so hoch wie die des die horizontale Komponente induzierenden Stroms ist und daß die Leiter (C) in Längsrichtung verlaufen und flach im wesentlichen parallel zu einer Achse (XX') installiert sind, wobei das Schiff (1) mindestens einmal über die im wesentlichen entlang der Achse (XX') verlaufenden Leiter (C) hinwegfährt.

2. Meßstation nach Anspruch 1, dadurch gekennzeichnet, daß die Leiter (C) sich am Meeresboden befinden.

3. Meßstation nach einem der Ansprüche 1 oder 2, dadurch gekennzeichnet, daß die Frequenz des die sich längs erstreckenden Leiter (C) speisenden Stroms gegenüber der einer realen Rollbewegung des Schiffes hoch ist.

4. Meßstation nach einem der Ansprüche 1 bis 3, dadurch gekennzeichnet, daß die Leiter (C) eine Länge (D) besitzen, die mindestens gleich der des Schiffes (1) ist.

5. Meßstation nach einem der Ansprüche 1 bis 4, dadurch gekennzeichnet, daß der Abstand (dL, dJ, dM) zwischen zwei aufeinanderfolgenden Leitern (C) gering im Vergleich zu ihrer Länge (D) ist.

6. Meßstation nach einem der Ansprüche 1 bis 5, dadurch gekennzeichnet, daß die Reihe (11) von magnetischen Meßsonden (12) quer zur Kursachse (XX') des Schiffes (1) verläuft, und zwar im wesentlichen in der Mitte dieser Leiter (C).

7. Meßstation nach einem der Ansprüche 1 bis 6, dadurch gekennzeichnet, daß das Schiff (1) aus unmagnetischem, aber elektrisch leitfähigem Material besteht.

8. Meßstation nach einem der Ansprüche 1 bis 7, dadurch gekennzeichnet, daß die Leiter (C) so zusammenwirken, daß sie mindestens eine Gruppe von drei Schleifen bilden, nämlich eine zentrale Schleife (J), die von einer ersten Speisequelle gespeist wird, die einen Strom zur Erzeugung der vertikalen Komponente (Bv) des Magnetfelds liefert, und zwei seitliche Schleifen (L, M), die von einer zweiten Quelle gespeist werden, welche einen zur Erzeugung der horizontalen Komponente (Bh) des Magnetfelds bestimmten Strom liefert, wobei diese Komponente quer zur Kursachse (XX') des Schiffes verläuft.

9. Meßstation nach einem der Ansprüche 1 bis 7, dadurch gekennzeichnet, daß die Leiter (C1 bis C5) an einem Ende alle in einem gemeinsamen Punkt verbunden und am anderen Ende mit einer elektrischen Speisequelle verbunden sind.

10. Meßstation nach Anspruch 9, dadurch gekennzeichnet, daß es fünf Leiter gibt.

11. Meßstation nach einem der Ansprüche 9 oder 10, dadurch gekennzeichnet, daß die Summe der in den Leitern fließenden Ströme in jedem Augenblick Null ist.

12. Meßstation nach einem der Ansprüche 9 bis 11, dadurch gekennzeichnet, daß in jedem Leiter ein Strom fließt, der die Summe eines zur Erzeugung der horizontalen Komponente des Magnetfelds bestimmten Stroms und eines zur Erzeugung der vertikalen Komponente des Magnetfelds bestimmten Stroms ist.

13. Meßstation nach einem der Ansprüche 9 bis 12, dadurch gekennzeichnet, daß jeder Leiter (C1 bis C5) an eine eigene Speisequelle (I1 bis I5) angeschlossen ist.

14. Meßstation nach Anspruch 12, dadurch gekennzeichnet, daß eine erste Speisequelle (IH) den zur Erzeugung der horizontalen Komponente des Magnetfelds bestimmten Strom und eine zweite Quelle (IV) den zur Erzeugung der vertikalen Komponente des Magnetfelds bestimmten Strom liefert.

15. Meßstation nach einem der Ansprüche 9 bis 11, dadurch gekennzeichnet, daß eine gemeinsame Speisequelle (AL) mit zwei Ausgängen (SV, SH) bei der Überfahrt des Schiffes (1) einen zur Erzeugung der horizontalen Komponente des Magnetfelds bestimmten Strom und bei einer weiteren Überfahrt des Schiffes einen zur Erzeugung der vertikalen Komponente des Magnetfelds bestimmten Strom liefert.

16. Verfahren zur Messung der magnetischen Kennung aufgrund der Foucaultströme, die durch eine Rollbewegung eines Schiffes erzeugt werden, wobei das Verfahren darin besteht:

   - mit Hilfe von Leitern, die mit einem Strom gespeist werden, ein drehendes Magnetfeld zu erzeugen, das die Rollbewegung simuliert und eine horizontale und eine vertikale Komponente besitzt,

dadurch gekennzeichnet, daß die Frequenz des die vertikale Komponente induzierenden Stroms doppelt so hoch wie die des die horizontale Komponente induzierenden Stroms ist, und daß das Verfahren weiter darin besteht,

- eine Gruppe von Daten zu erfassen, die von mindestens einer Reihe von Magnetmeßsonden geliefert wird, welche mit den elektrischen Leitern zusammenwirken, wobei die Leiter in Längsrichtung verlaufen und im wesentlichen parallel zu einer Achse flach angeordnet sind und wobei das Schiff mindestens einmal entlang dieser Achse über die Reihe fährt,
- eine weitere Gruppe von Daten zu erfassen, die von der Reihe von Magnetmeßsonden geliefert wird, wenn kein Schiff über die Reihe fährt,
- die beiden Gruppen von Daten voneinander zu subtrahieren, um eine dritte Gruppe von Daten zu erhalten.

17. Meßverfahren nach Anspruch 16, dadurch gekennzeichnet, daß es darin besteht, mindestens eine der Gruppen von Daten zu verarbeiten, um das Verhältnis zwischen der Frequenz der simulierten Rollbewegung und der Frequenz der realen Rollbewegung zu berücksichtigen.

18. Meßverfahren nach einem der Ansprüche 16 oder 17, dadurch gekennzeichnet, daß es darin besteht, das statische Erdmagnetfeld durch eine Filterung mindestens einer dieser Gruppen von Daten auszuschalten.

**Claims**

1. Station for measuring the magnetic signature of a naval vessel (1), able to measure the magnetic signature due to the eddy currents generated during a roll by the naval vessel (1), including at least one line (11) of magnetic sensors (12) interacting with conductors (C) producing a rotating magnetic field around the vessel (1), when they are supplied with current, this magnetic field having a horizontal component and a vertical component and simulating the roll, characterized in that the frequency of the current inducing the vertical component is twice that of the current inducing the horizontal component, and in that the conductors (C) are longitudinal and are installed flat and substantially parallel to an axis (XX'), the naval vessel (1) making at least one pass above the conductors (C) substantially along the said axis (XX').

2. Measurement station according to Claim 1, characterized in that the conductors (C) are arranged on the sea bed.

3. Measurement station according to one of Claims 1 and 2, characterized in that the frequency of the current being supplied to the longitudinal conductors (C) is high when set against that of an actual roll by the naval vessel.

4. Measurement station according to one of Claims 1 to 3, characterized in that the conductors (C) have a length (D) which is at least equal to that of the naval vessel (1).

5. Measurement station according to one of Claims 1 to 4, characterized in that the spacing (dL, dJ, dM) between two successive conductors (C) is small with respect to their length (D).

6. Measurement station according to one of Claims 1 to 5, characterized in that the line (11) of magnetic sensors (12) is arranged transversely to the axis (XX') of passage of the vessel (1), substantially in the middle of the conductors (C).

7. Measurement station according to one of Claims 1 to 6, characterized in that the vessel (1) is made of electrically conducting non-magnetic material.

8. Measurement station according to one of Claims 1 to 7, characterized in that the conductors (C) interact in such a way as to form at least one set of three loops, with a central loop (J) powered by a first power supply supplying a current intended to produce the vertical component (Bv) of the magnetic field and two lateral loops (L, M) powered by a second power supply supplying a current intended to produce the horizontal component (Bh) of the magnetic field, this component being transverse to the axis (XX') of passage of the vessel.

9. Measurement station according to one of Claims 1 to 7, characterized in that the conductors (C1 to C5) are all linked on one side to a common point and on the other to an electrical power supply.

10. Measurement station according to Claim 9, characterized in that the conductors are five in number.

11. Measurement station according to one of Claims 9 and 10, characterized in that the sum of the currents flowing in the conductors is zero at all times.

12. Measurement station according to one of Claims 9 to 11, characterized in that, in each conductor, a current flows which is the sum of a current intended to produce the horizontal component of the magnetic field and of a current intended to produce the vertical component of the magnetic field.

13. Measurement station according to one of Claims 9 to 12, characterized in that each conductor (C1, C2, C3, C4, C5) is linked to a separate power supply (I1, I2, I3, I4, I5).

14. Measurement station according to Claim 12, characterized in that a first power supply (IH) supplies the current intended to produce the horizontal component of the magnetic field, and a second power supply (IV) supplies the current intended to produce the vertical component of the magnetic field.

15. Measurement station according to one of Claims 9 to 11, characterized in that a single power supply (AL) with two outputs (SV, SH), during a pass by the vessel (1), supplies a current intended to produce a horizontal component of the magnetic field and, during another pass by the vessel, supplies a current intended to produce the vertical component of the magnetic field.

16. Method of measuring the magnetic signature due to eddy currents generated during a roll of a naval vessel consisting

   - in producing a rotating magnetic field simulating the roll and having a horizontal component and a vertical component, by the use of conductors supplied with current, characterized in that the frequency of the current inducing the vertical component is twice that of the current inducing the horizontal component, and in that the method consists in :
   - gathering a set of data supplied by at least one line of magnetic sensors interacting with the electrical conductors, these conductors being longitudinal, arranged flat and substantially parallel to an axis, the naval vessel making at least one pass substantially along this axis,
   - gathering another set of data supplied by the line of magnetic sensors in the absence of the naval vessel,
   - subtracting the two sets of data in order to obtain a third set of data.

17. Measurement method according to Claim 16, characterized in that it consists in processing at least one of the sets of data in order to take account of the ratio between the frequency of the simulated roll and the frequency of the actual roll.

18. Measurement method according to one of Claims 16 and 17, characterized in that it consists in disposing of the static terrestrial magnetic field by filtering of at least one of the sets of data.

Ih sin ωt

Iv sin 2ωt

FIG.1

FIG. 2

FIG.3

FIG.4a

FIG.4b

FIG.5

EP 0 671 013 B1

EP 0 671 013 B1

FIG.6